# EUROPÄISCHE PATENTANMELDUNG

(11) **EP 2 360 416 A1**
(43) Veröffentlichungstag der Anmeldung: **24.08.2011**
(21) Anmeldenummer: 10003395.0
(22) Anmeldetag: 30.03.2010
(51) Int. Cl.: F21K 99/00

(54) **Leuchteinrichtung und Verfahren zur Herstellung einer solchen**

(30) Priorität: 24.02.2010 AT 2782010
(71) Anmelder: EV Group GmbH, 4782 St. Florian am Inn (AT)
(72) Erfinder: Thallner, Erich, 4782 St. Florian (AT)
(74) Vertreter: Schweiger, Johannes

(57) **Zusammenfassung**

Die Erfindung betrifft eine Leuchteinrichtung mit
- einem flächigen Träger mit einer oberen Flachseite und einer Unterseite zur Aufnahme von Leuchtmitteln in jeweils zwischen der oberen Flachseite und der Unterseite liegenden, mindestens zu einer Seite offenen, entlang der oberen Flachseite verteilten Kammern und
- einem, auf der oberen Flachseite des Trägers fixierbaren, lichtdurchlässigen Deckel mit einer unteren Flachseite zur Abdeckung jeweils mindestens einer der Kammern, wobei die Leuchtmittel über Stromanschlüsse zum Anschluss der Leuchtmittel in den Kammern ansteuerbar sind.

## Beschreibung

Die Erfindung betrifft eine Leuchteinrichtung gemäß Patentanspruch 1 und ein Verfahren zur Herstellung einer Leuchteinrichtung gemäß Patentanspruch 10.

Leuchteinrichtungen bestehen aus vielen mechanischen und optischen Komponenten und deren Herstellung in Massenfertigung ist aufwendig, da die Vielzahl von einzelnen Komponenten jeweils einzeln zusammengefügt werden muss. Besonders aufwendig ist die Herstellung großflächiger Beleuchtungskörper mit gleichmäßiger Abstrahlcharakteristik, insbesondere beim Einsatz von LEDs. Auch der Ersatz von herkömmlichen Glühbirnen spielt eine erhebliche Rolle da diese mehr und mehr vom Markt verschwinden, unter anderem aufgrund gesetzlicher Vorgaben.

Aufgabe der vorliegenden Erfindung ist es, eine Leuchteinrichtung und ein Verfahren zur Herstellung einer solchen anzugeben, mit welchem ein flexibler Einsatz und eine kostengünstige Herstellung mit hohem Durchsatz ermöglicht wird.

Diese Aufgabe wird mit den Merkmalen der Ansprüche 1 oder 10 gelöst. Vorteilhafte Weiterbildungen der Erfindung sind in den Unteransprüchen angegeben. In den Rahmen der Erfindung fallen auch sämtliche Kombinationen aus zumindest zwei der in der Beschreibung, in den Ansprüchen und/oder den Zeichnungen angegebenen Merkmale. Bei angegebenen Wertebereichen sollen auch innerhalb der genannten Grenzen liegende Werte als Grenzwerte offenbart gelten und in beliebiger Kombination beanspruchbar sein.

Der Erfindung liegt der Gedanke zu Grunde, mit einer minimalen Anzahl von Bauteilen eine Vielzahl von Leuchtmitteln beziehungsweise Leuchteinrichtungen herzustellen. Hierzu ist ein flächiger Beleutungskörper mit Leuchtdioden vorgesehen, wobei die Leuchtmittel, insbesondere LED Chips zwischen einem Optikelement und einem Leuchtmittelträger platziert sind. Hierdurch wird die Herstellung großer Flächen mit einer Vielzahl von Leuchtmitteln, insbesondere LEDs, parallel möglich und es können normierte Flächenelemente gestaltet werden, die alle dieselben Abmessungen aufweisen. LED Chips werden dabei, insbesondere vereinzelt, in Kavitäten des Trägers, also Kammern, montiert, wobei die Kavitäten gleichzeitig als Reflektor für seitlich und nach unten aus den Leuchtmitteln austretende Lichtstrahlen dienen können. Erfindungsgemäß ist dabei von besonderem Vorteil, wenn der flächige Träger eine obere Flachseite aufweist, von der sich die Kammern nach hinten, also zur Unterseite des flächigen Trägers erstrecken. Die Kammern überragen damit die obere Flachseite des flächigen Trägers nicht. Auf die Weise ist die obere Flachseite flächenbündig mit einem eine untere Flachseite aufweisenden Deckel abdeckbar. Hierdurch wird außerdem ermöglicht, eine quasi vollflächige Fixierung des Deckels auf dem Träger zu realisieren, also beispielsweise auch zwischen den über die obere Flachseite verteilten Kammern. Eine Kodierung und/oder Rastmittel auf den beiden korrespondierenden Flachseiten, nämlich der oberen Flachseite des Trägers und der unteren Flachseite des Deckels, kann in vorteilhafter Ausgestaltung der Erfindung vorgesehen sein. Eine großflächige Herstellung einer solchen Leuchteinrichtung, besonders bevorzugt auf einem Wafer als flächigen Träger, insbesondere mit einem Durchmesser von 20 oder 30 Zentimetern, ist mit rasantem Durchsatz möglich. Die so hergestellten, großflächigen Leuchteinrichtungen sind sogar beliebig in kleinere Leuchteinrichtungen teilbar, insbesondere durch aus der Wafertechnologie bekannte Schneidetechniken.

In vorteilhafter Ausgestaltung der Erfindung ist es darüber hinaus möglich, die für die einzelnen Kammern und einzelnen Leuchtmittel erforderlichen Leitungen in den Träger zu integrieren.

Als Trägermaterial kommen außer Siliziumwafer mit geätzten Kavitäten beziehungsweise Kammern im Sinne der vorliegenden Erfindung auch Glas oder Kunststoff (gepresst, gegossen) oder Metall (tiefgezogen oder Guss) in Frage. Mit Vorteil ist der flächige Träger und/oder der Deckel einstückig, insbesondere monolithisch, ausgebildet.

In einer vorteilhaften Ausführungsform der Erfindung ist vorgesehen, dass der Deckel, insbesondere für jede Kammer gesonderte, Optikmittel zur Beeinflussung der von den Leuchtmitteln ausgegebenen Lichtstrahlen aufweist. Besonders vorteilhaft ist es dabei, wenn die Optikmittel integral im Deckel integriert sind, beispielsweise durch Oberflächenbearbeitung des Deckels oder durch linsenförmige Ausformung.

Besonders bevorzugt ist es dabei, wenn die Optikmittel durch, insbesondere jeder Kammer getrennt zugeordnete, Optikstrukturen an der Außenkontur des Deckels, insbesondere an einer dem Träger abgewandten Leuchtseite des Deckels, vorgesehen sind. Eine solche Optikstruktur kann beispielsweise in die Oberfläche des Deckels gepresst sein, insbesondere bei einem Deckel aus transparentem Kunststoff. Die Struktur kann außerdem als Beschichtung, insbesondere als strukturierter Lack aufgebracht werden. Besonders vorteilhaft ist es, wenn Strukturelemente der Optikstruktur Größen unterhalb der Wellenlänge des sichtbaren Lichts haben, da hierdurch ein zusätzlicher Freiheitsgrad im optischen Design erreicht wird.

In einer vorteilhaften Ausgestaltung der Erfindung ist vorgesehen, dass die Lichtstrahlen streuende und/oder bündelnde Optikmittel aufweisen. Gerade durch Kombination der beiden Maßnahmen kann eine erfordernde Ausleuchtung durch die Leuchteinrichtung erzielt werden.

Indem die Kammern, insbesondere wannenförmig mit einem Wannenboden und einer, vorzugsweise angewinkelten Umfangswand, insbesondere flächenbündig mit der Flachseite, in die Flachseite eingelassen, insbesondere eingeätzt sind, sind die Kammern kostengünstig in großer Zahl herstellbar, ohne zusätzliche Materialien oder Bauteile zu verwenden.

Gemäß einer weiteren vorteilhaften Ausführungsform der Erfindung sind der Wannenboden und/oder die Umfangswand, insbesondere durch eine, vorzugsweise durch Metallisierung gebildete, Reflektorschicht, reflektierend ausgebildet. Durch diese Maßnahme wird die Lichtausbeute in Strahlungsrichtung also in Richtung des Deckels, verbessert.

Soweit als Leuchtmittel LEDs, insbesondere eine einzige LED pro Kammer, vorgesehen sind, ist die Leuchteinrichtung besonders sparsam und langlebig realisierbar. Die LEDs sind besonders bevorzugt als SMDs (oberflächenmontierte elektronische Bauteile) ausgebildet. Ebenso bevorzugt ist die COB-Bauform (Chip on Board). Alternativ ist es von besonderem Vorteil, die LEDs als Rohchips (sogenannte "dies") zu montieren.

Indem die Leuchtmittel über die Flachseite gleichmäßig verteilt, insbesondere zueinander fluchtend, angeordnet sind, wird die Herstellung der Leuchteinrichtung weiter vereinfacht und ein späteres Teilen einer großflächig hergestellten Leuchteinrichtung, beispielsweise durch Schneiden, wird ermöglicht.

In einer besonders bevorzugten Ausführungsform der Erfindung ist vorgesehen, dass die Optikstruktur bildende, insbesondere durch Lithografieverfahren, vorzugsweise Nanoimprint-Lithografieverfahren, hergestellte, Strukturelemente Abmessungen kleiner als die Wellenlänge des sichtbaren Lichts aufweisen.

Weitere Vorteile, Merkmale und Einzelheiten der Erfindung ergeben sich aus der nachfolgenden Beschreibung bevorzugter Ausführungsbeispiele sowie an Hand der Zeichnungen. Diese zeigen in:
- Fig. 1 :: Eine geschnittene Seitenansicht einer erfindungsgemäßen Leuchteinrichtung,
- Fig. 2:: eine Aufsicht auf die erfindungsgemäße Leuchteinrichtung gemäß Figur 1 und
- Fig. 3:: eine geschnittene Seitenansicht einer alternativen Ausführungsform der erfindungsgemäßen Leuchteinrichtung mit die Lichtstrahlen streuenden Optikmitteln.

In den Figuren sind gleiche Bauteile und Bauteile mit der gleichen Funktion mit den gleichen Bezugszeichen gekennzeichnet.

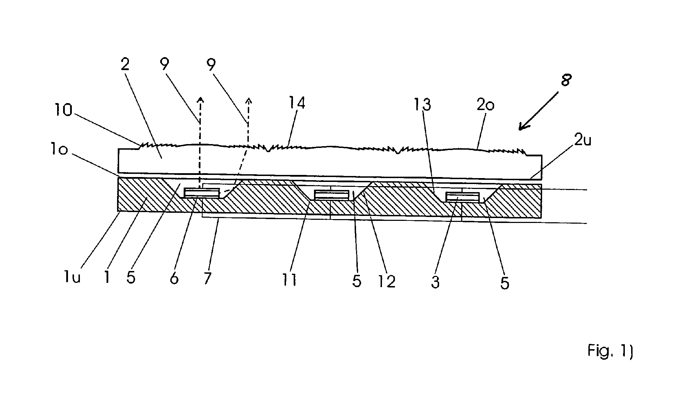

In Figur 1 ist schematisch ein flächiger Träger 1 aus Halbleitermaterial dargestellt, der eine in der Figur unten liegende Unterseite 1u und eine in der Figur oben liegende obere Flachseite 1o aufweist. Der Träger 1 ist als runde Scheibe oder winkeliges Substrat ausgebildet und damit besonders leicht handhabbar, beispielsweise durch aus der Halbleiterindustrie bekannte Verfahren und Vorrichtungen bei der Waferbearbeitung.

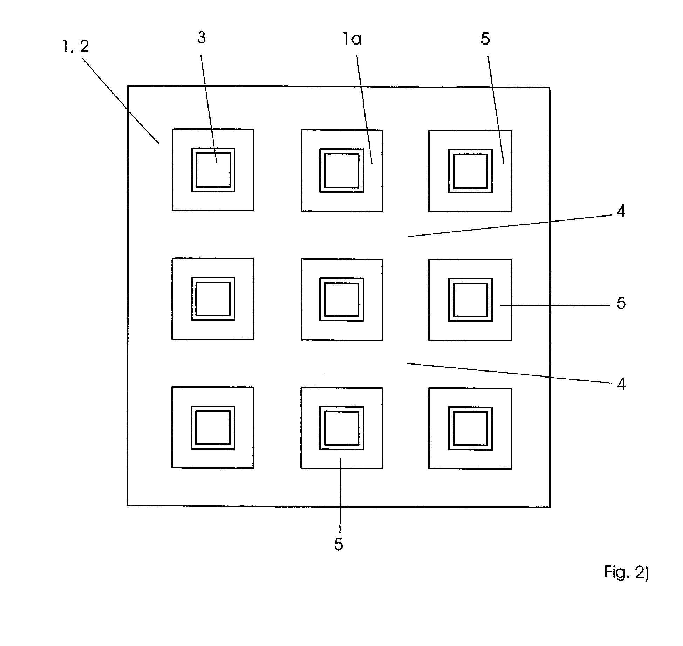

In den Träger 1 sind eine Vielzahl von Kammern 5 eingeätzt, wobei im Ausführungsbeispiel neun Kammern 5 (siehe Figur 2) vorgesehen sind. Ebenso ist es denkbar, eine viel größere Fläche zu bestücken. Die Darstellung in den Figuren ist stark vergrößert.

Die Kammern 5 erstrecken sich von der oberen Flachseite 1o des Trägers 1 ausschließlich in Richtung der Unterseite 1u und enden etwa äquidistant zu der oberen Flachseite 1o und der Unterseite 1u mit einem Wannenboden 11, der parallel zur oberen Flachseite 1o und zur Unterseite 1u angeordnet ist.

Eine Umfangswand 12 jeder Kammer 5 verläuft vorzugsweise von dem Wannenboden 11 schräg nach außen, insbesondere in einem Winkel zwischen 30 und 60 Grad, vorzugsweise 45 Grad bezogen auf den Wannenboden. Andere optische Ausführungen umfassen parabolische, elliptische Wände beziehungsweise Freiformflächen, welche auf die Abstrahlcharahteristik der LEDs abgestimmt sind.

Auf dem Wannenboden 11 sind LEDs als Leuchtmittel 3 fixiert und gleichzeitig mit Stromanschlüssen 6 verbunden, die über elektrische Leitungen 7 zu einer nicht dargestellten Steuerung mit einer Stromquelle führen. Über die Steuerung können die LEDs einzeln, in Gruppen oder gemeinsam angesteuert werden.

Auf dem Träger 1 ist ein mit dem Träger 1 korrespondierender Deckel 2 aufgeklebt oder geklemmt, wobei als Kontaktfläche eine untere Flachseite 2u des Deckels 2 mit der oberen Flachseite lo dient. Als aktive Klebefläche kann für eine besonders innige Verbindung die gesamte, die Kammern 5 umgebende Kontaktfläche zwischen dem Träger 1 und dem Deckel 2 dienen. Auch eine punktuelle Verklebung an Kreuzungspunkten 4 zwischen jeweils vier benachbarten Kammern 5 ist erfindungsgemäß ebenfalls denkbar.

Besonders vorteilhaft ist aber eine Klemmverbindung, insbesondere mittels Schrauben, Federn oder ähnlichen Klemmmitteln, da dann trotz unterschiedlicher thermischer Dehnung der Materialen eine sichere Verbindung gewährleistet wird.

Gegenüberliegend zur unteren Flachseite 2u ist eine Leuchtseite 2o vorgesehen, aus der von den Leuchtmitteln 3 erzeugte Lichtstrahlern 9 in Richtung eines zu beleuchtenden Gegenstandes aus der Leuchteinrichtung austreten.

An der Leuchtseite 2o sind Optikmittel 8, nämlich bei der vorliegenden Ausführungsform gemäß Figur 1 bündelnde Optikmittel als Optikstrukturen 10 vorgesehen. Die Optikstrukturen 10 bestehen aus einzelnen Strukturelementen 14, deren Abmessungen kleiner als die Wellenlänge des sichtbaren Lichts, insbesondere kleiner 400 Nanometer, vorzugsweise kleiner 200 Nanometer sind.

Die Optikstruktur 10 ist derart ausgebildet, dass die auf der jeweils zugeordneten Kammer 5 austretenden Lichtstrahlen überwiegend derart reflektiert werden, dass diese parallel gerichtet sind, nämlich in Richtung des zu beleuchtenden Gegenstandes, also orthogonal zur oberen Flachseite 1o. Mit einer solchen Leuchteinrichtung können beispielsweise Spots realisiert werden.

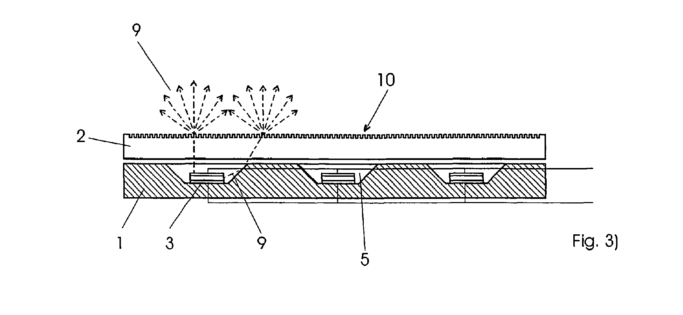

Die in Figur 3 gezeigte Leuchteinrichtung sorgt dagegen durch eine mäanderförmige Optikstruktur 10 für eine Streuung der aus den Kammern 5 austretenden Lichtstrahlen 9, was für eine großflächige Beleuchtung, beispielsweise große Hallen sinnvoll sein kann. Bei der dort gezeigten Ausführungsform findet eine überaus gleichmäßige Ausleuchtung und Verteilung der von den Leuchtmitteln 3 erzeugten Lichtstrahlen statt.

In einer besonders vorteilhaften Ausführungsform der Leuchteinrichtung kann vorgesehen sein, dass der Deckel 2 austauschbar ist, beispielsweise durch Rastmittel zur Verbindung des Deckels 2 mit dem Träger 1.

Als Optikmittel 8 können auch Linsenstrukturen oder Fresnel-Linsen eingesetzt werden.

### Bezugszeichenliste

- 1: Träger
- 1 u: Unterseite
- 10: Obere Flachseite
- 2: Deckel
- 2u: Untere Flachseite
- 2o: Leuchtseite
- 3: Leuchtmittel
- 4: Kreuzungspunkte
- 5: Kammern
- 6: Stromanschlüsse
- 7: Elektrische Leitungen
- 8: Optikmittel
- 9: Lichtstrahlen
- 10: Optikstrukturen
- 11: Wannenboden
- 12: Umfangswand
- 13: Reflektorschicht
- 14: Strukturelement

## Patentansprüche

1. Leuchteinrichtung mit:
- einem flächigen Träger (1) mit einer oberen Flachseite (1o) und einer Unterseite (1u) zur Aufnahme von Leuchtmitteln (3) in jeweils zwischen der oberen Flachseite (1o) und der Unterseite (1u) liegenden, mindestens zu einer Seite offenen, entlang der oberen Flachseite (1o) verteilten Kammern (5) und
- einem, auf der oberen Flachseite (1o) des Trägers (1) fixierbaren, lichtdurchlässigen Deckel (2) mit einer unteren Flachseite (2u) zur Abdeckung jeweils mindestens einer der Kammern (5), wobei
die Leuchtmittel (3) über Stromanschlüsse (6) zum Anschluss der Leuchtmittel (3) in den Kammern (5) ansteuerbar sind.

2. Leuchteinrichtung nach Anspruch 1, bei der der Deckel (2), insbesondere für jede Kammer (5) gesonderte, Optikmittel (8) zur Beeinflussung der von den Leuchtmitteln (3) ausgegebenen Lichtstrahlen (9) aufweist.

3. Leuchteinrichtung nach Anspruch 2, bei der die Optikmittel (8) durch, insbesondere jeder Kammer (5) getrennt zugeordnete, Optikstrukturen (10) an der Außenkontur des Deckels (2), insbesondere an einer dem Träger (1) abgewandten Leuchtseite (2o) des Deckels (2), vorgesehen sind.

4. Leuchteinrichtung nach Anspruch 2 oder 3, bei der die Lichtstrahlen (9) streuende und/oder bündelnde Optikmittel (8) vorgesehen sind.

5. Leuchteinrichtung nach einem der vorhergehenden Ansprüche, bei der die Kammern (5), insbesondere wannenförmig mit einem Wannenboden (11) und einer, vorzugsweise angewinkelten Umfangswand (12), insbesondere flächenbündig mit der Flachseite (1o), in die Flachseite (1o) eingelassen, insbesondere eingeätzt, sind.

6. Leuchteinrichtung nach Anspruch 5, bei der der Wannenboden (11) und/oder die Umfangswand (12), insbesondere durch eine, vorzugsweise durch Metallisierung gebildete, Reflektorschicht (13), reflektierend ausgebildet sind.

7. Leuchteinrichtung nach einem der vorhergehenden Ansprüche, bei der als Leuchtmittel (3) LEDs, insbesondere eine einzige LED pro Kammer (5), vorgesehen sind.

8. Leuchteinrichtung nach einem der vorhergehenden Ansprüche, bei der die Leuchtmittel (3) über die Flachseite (1o) gleichmäßig verteilt, insbesondere zueinander fluchtend, angeordnet sind.

9. Leuchteinrichtung nach einem der vorhergehenden Ansprüche, bei der die Optikstruktur (10) bildende, insbesondere durch Lithografieverfahren, vorzugsweise Nanoimprint-Lithografieverfahren, hergestellte, Strukturelemente (14) Abmessungen kleiner als die Wellenlänge des sichtbaren Lichts aufweisen.

10. Verfahren zur Herstellung einer Leuchteinrichtung nach einem der vorhergehenden Ansprüche mit folgenden Schritten:
- Ausformung von auf einer Flachseite eines Trägers verteilten Kammern zur Aufnahme von Leuclitmitteln
- Einbringung der Leuchtmittel in die Kammern und Anschluss der Leuchtmittel an über durch den Träger verlaufende elektrische Leitungen ansteuerbare Stromanschlüsse,
- Ausbildung eines, auf der Flachseite des Trägers fixierbaren, lichtdurchlässigen, flächigen Deckels zur Abdeckung jeweils mindestens einer der Kammern und
- Ausrichtung und Fixierung des Deckels auf dem Träger.
